# EUROPÄISCHE PATENTANMELDUNG

(11) **EP 0 851 537 A2**
(43) Veröffentlichungstag der Anmeldung: **01.07.1998**
(21) Anmeldenummer: 97119608.4
(22) Anmeldetag: 10.11.1997
(51) Int. Cl.: H01R 13/658

(54) **Kabelgehäuse**

(30) Priorität: 08.11.1996 DE 19646063
(71) Anmelder: AEG Intermas GmbH, 64546 Mörfelden-Walldorf (DE)
(72) Erfinder: Haxel, Gerd, 63500 Seligenstadt (DE); Bohnenberger, Willi, 63533 Mainhausen (DE); Klatt, Michael, 60437 Frankfurt (DE); Reichard, Helmut, 63694 Limeshain (DE)
(74) Vertreter: Stoffregen, Hans-Herbert, Dr. Dipl.-Phys.

(57) **Zusammenfassung**

Die Erfindung bezieht sich auf ein Kabelgehäuse (30, 38, 114) zur Aufnahme eines Steckverbinders (28) wie Feder- oder Messerleiste zum Verbinden mit einem Steckverbinder (26) wie Messer- oder Federleiste einer in einem abgeschirmten Gehäuse wie Baugruppenträger (10) anordbaren Baugruppe (24). Um im Bereich zwischen dem Gehäuse und einem eingesteckten Steckverbinder eine hinreichende Abschirmung gegen elektromagnetische Felder zu erreichen, wird vorgeschlagen, daß das Kabelgehäuse einen Kontakt- und/oder Federschenkel zur Ausbildung einer elektrisch leitenden Verbindung mit einem angrenzenden weiteren Kabelgehäuse oder einem Abschnitt des abgeschirmten Gehäuses (10) aufweist.

## Beschreibung

Die Erfindung bezieht sich auf ein Kabelgehäuse zur Aufnahme eines Steckverbinders wie Feder- oder Messerleiste zum Verbinden mit in einem Gehäuse insbesondere in einem Baugruppenträger anordbaren elektronischen Baugruppen, wobei das Kabelgehäuse zwei miteinander verbindbare Gehäuseschalen umfaßt, die jeweils Seitenwände, Rückwand und Basiswand aufweisen.

Ein entsprechendes Kabelgehäuse ist der DE 26 11 941 C3 zu entnehmen. In dem bekannten Kabelgehäuse können alle Steckverbinder der Reihe 1, 2 und 3 der DIN-Norm 41 612 verwendet werden, wobei der Steckverbinder selbst von vorne als auch von hinten in den Baugruppenträger gesteckt werden kann. Um das Kabelgehäuse leicht und genau stecken zu können, ist eine Führung vorgesehen, die ein von einem Bauträger ausgehendes Befestigungselement und eine diesem zuordbare Nut am Kabelgehäuse umfassen.

Um Baugruppenträger sowohl gegen äußere elektromagnetische Felder als auch einen Raum außerhalb des Baugruppenträgers vor den im Baugruppeninneren erzeugten elektromagnetischen Feldern abzuschirmen oder zumindest die austretenden elektromagnetischen Strahlungen zu dämpfen, insbesondere im Bereich von Frontplatten, wird nach der DE 41 14 484 C2 ein Baugruppenträger mit U-förmig ausgebildeten metallischen oder metallisierten Frontplatten, vorgeschlagen, von denen in Schenkel als Federschenkel zur Aufnahme einer Blattfeder und der andere Schenkel als Kontaktschenkel für die leitende Verbindung mit der Blattfeder einer benachbarten Frontplatte ausgebildet sind. Durch diese Maßnahmen ist sichergestellt, daß über die Front des Baugruppenträgers, also zwischen den Frontplatten selbst elektromagnetische Strahlung nicht nach außen gelangen kann.

Eine Schwachstelle der Abschirmung ist jedoch dort gegeben, wo über Steckverbinder Anschlüsse von Leitungen bzw. Kabeln an die Bauelemente der Baugruppenträger geführt werden.

Der vorliegenden Erfindung liegt das Problem zugrunde, ein Kabelgehäuse der eingangs genannten Art so weiterzubilden, daß dieses eine Abschirmung ermöglicht, wenn Steckerverbinder in ein abgeschirmtes Gehäuse gesteckt sind, insbesondere dann, wenn Steckverbindungen im Bereich von Frontplatten eines Baugruppenträgers geführt werden.

Das Problem wird erfindungsgemäß im wesentlichen dadurch gelöst, daß von der Basiswand Gehäuseschale ausgehend oder entlang dieser sich erstreckend ein Kontakt- oder Federschenkel zur Ausbildung einer leitenden Verbindung mit einem angrenzenden weiteren Kabelgehäuse oder einem Abschnitt des abgeschirmten Gehäuses ausgeht. Dabei wird unter Abschnitt eines Gehäuses wie Baugruppenträgers auch eine Frontplatte verstanden.

Insbesondere ist der Kontakt- bzw. Federschenkel integral mit der Basiswand ausgebildet. So sieht eine bevorzugte Ausführungsform der Erfindung vor, daß der Federschenkel vorderer randseitiger Abschnitt der Basiswand ist, daß außenseitig und bündig in die Basiswand übergehend ein Abschnitt eines sich entlang der Basiswand erstreckenden Federelementes verläuft, das sich bis zur Innenseite der Basiswand hin erstreckt. Dabei handelt es sich bei dem Federelement vorzugsweise um ein blattfederartiges Element. Losgelöst hiervon erstreckt sich das Federelement entlang der gesamten oder nahezu der gesamten Breite der Außenwandung, so daß der erforderliche elektrisch leitende Kontakt mit einem angrenzenden Kabelgehäuse bzw. einem Abschnitt des Baugruppenträgers wie Frontplatte sichergestellt ist.

Das von der Außenseite ausgehende Federelement erstreckt sich bis zur Innenseite der Basiswand, wobei der Außenschenkel des im Schnitt einer U-Form mit unterschiedlichen Schenkellängen aufweisenden Federelementes nach außen gewölbt ist, um vorgespannt an dem angrenzenden Kabelgehäuse oder einem Baugruppenträgernabschnitt anzuliegen. Dabei ist jedoch die Federcharakteristik so gewählt, daß der Kraftaufwand beim Einschieben und Herausziehen gegenüber angrenzenden Elementen gering ist.

Insbesondere besteht das Federelement aus parallel zueinander verlaufenden Längsstreifen, die über senkrecht zu diesen verlaufenden und zueinander beabstandeten Querstreifen verbunden sind. Im flächig ausgebreiteten Zustand weist die Blattfeder folglich in Draufsicht eine Leitergeometrie auf.

Im eingebauten Zustand verlaufen die Längsstreifen entlang der Innen- bzw. Außenseite der Basiswand und parallel zum Längsrand des Federschenkels.

Damit der äußere freie Rand des Federelementes eine Behinderung beim Einstecken bzw. Herausziehen angrenzender Elemente nicht dargestellt, ist vorgesehen, daß der äußere Längsstreifen randseitig an einer Stufe der Basiswand angrenzt, wodurch der gewünschte bündige Übergang erfolgt. Selbstverständlich besteht auch die Möglichkeit, den Längsstreifen in bezug auf die Stufe zurückversetzt verlaufen zu lassen.

Der äußere Längsstreifen selbst kann an der Basiswand z.B. durch Kleben befestigt sein. Andere Verbindungsmöglichkeiten bestehen gleichfalls. Auch kann der äußere freienLängsrand des Federelementes durch Widerlager in einer Längsnut oder in einer über die Breite der Basiswand verlaufenden kammerförmigen Ausnehmung festgelegt werden. Gleiches gilt in bezug auf den freien Rand des inneren Längsstreifens des Federelementes.

Bevorzugterweise weist der Federschenkel eine derartige Geometrie auf, daß die Außenwand randseitig nach innen abgewinkelt ist und innenwandseitig eine Längsnut aufweist, die zwischen dem nach innen abgewinkelten Längsrand und parallel zur Außenfläche verlaufender Innenfläche der Basiswand verläuft.

Um das Kabelgehäuse aus zwei gleich aufgebauten Gehäuseschalen aufbauen zu können, sollte der Kontaktschenkel gleich dem Federschenkel ausgebildet sein.

Die Erfindung bezieht sich auch auf ein Kabelgehäuse, wobei zumindest eine Gehäuseschale eine von deren Vorderseite ausgehende Aussparung aufweist, und ist dadurch gekennzeichnet, daß die Aussparung von einem mit der Gehäuseschale verbindbaren Blechelement mit parallel zum Längsrand der Gehäuseschale verlaufenden und über diesen vorstehenden Randabschnitt abgedeckt ist, der als Kontakt- oder Federschenkel zur Ausbildung einer leitenden Verbindung mit einem angrenzenden weiteren Kabelgehäuse oder einem Abschnitt des abgeschirmten Gehäuses wie Baugruppenträgers ausgebildet ist. Dabei ist der Randabschnitt des Blechelementes nach innen umgebogen.

Der insbesondere die Funktion eines Kontaktschenkels ausübende vordere umgekantete Rand wirkt dabei als reibschlüssiger Schneider, um die gewünschte elektrisch leitende Verbindung sicherzustellen.

Eine solche Konstruktion ist insbesondere dann von Vorteil, wenn nur wenig Raum als Steckplatz zur Verfügung steht; denn das Blechelement kann hinreichend dünn gewählt werden, so daß ein Einstecken nicht behindert werden kann. Um dennoch dem Blechelement die hinreichende Stabilität zu verleihen, kann dieses basiswandseitig zumindest abschnittsweise abgekantet sein und in entsprechende Aufnahmen wie Nuten der Basiswand eingebracht werden. Losgelöst hiervon sollte das Blechelement mit der Gehäuseschale verschraubt sein.

Alternativ besteht die Möglichkeit, daß außenseitig entlang der Basiswand der die Aussparung aufweisenden Gehäuseschale ein die Aussparung abdeckender Aufsatz befestigbar ist, entlang dessen Stirnseite ein sich an dem abgeschirmten Gehäuse wie Baugruppenträger oder einem Abschnitt von diesem anlegendes Federelement erstreckt. Eine solche Konstruktion ist dann geeignet, wenn seitlich neben dem Stecker hinreichend Platz zur Verfügung steht.

Nach einer bevorzugten Weiterbildung der Erfindung sollte die integral einen Schenkel aufweisende Basiswand beabstandet zu diesem und parallel zu dessen Längsrand verlaufend eine Aufnahme für ein über die Breite oder nehzu die Breite der Basiswand erstreckendes weiteres Federelement aufweisen. Eine solche Konstruktion ist insbesondere dann von Vorteil, wenn Kabelgehäuse aneinandergereiht werden. Dabei sollte in der Außenfläche der Basiswand eine parallel zu deren Stirnrand verlaufende schlitz- oder taschenförmige Aufnahme für einen Längsrand des entlang der Basiswand verlaufenden weiteren Federelementes wie Blattfeder vorgesehen sein, dessen anderer Längsrand (100) von einem U- oder kreisabschnittförmig gebogenen Endbereich der Blattfeder ausgeht, der von einem eine kammerförmige Aussparung außenseitig begrenzenden Steg gehalten ist. Andere Befestigungsmöglichkeiten des Federelementes sind gleichfalls möglich.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen:

Es zeigen:
- Fig. 1: ein Kabelgehäuse mit Steckverbinder zum Einstecken in einen Baugruppenträger, teilweise im Schnitt dargestellt,
- Fig. 2: einen Ausschnitt eines Baugruppenträgers mit Steckverbinder aufnehmenden Kabelgehäusen einer ersten Ausführungsform, teilweise in Explosionsdarstellung,
- Fig. 3: eine vergrößerte Darstellung des Bereichs X in Fig. 2,
- Fig. 4: eine vergrößerte Darstellung des Bereichs Y in Fig. 2,
- Fig. 5: einen Ausschnitt eines Baugruppenträgers mit Steckverbinder aufweisenden Kabelgehäusen einer zweiten Ausführungsform, teilweise in Explosionsdarstellung,
- Fig. 6: eine vergrößerte Darstellung des Bereichs X in Fig. 5,
- Fig. 7: eine vergrößerte Darstellung des Bereichs Y in Fig. 5,
- Fig. 8: im Ausschnitt einen Frontbereich eines Baugruppenträgers mit Kabelgehäuse,
- Fig. 9: einen Schnitt durch das Kabelgehäuse gemäß Fig. 8,
- Fig. 10: eine weitere Ausführungsform eines Kabelgehäuses mit Baugruppenträger, perspektivisch und im Ausschnitt,
- Fig. 11: eine perspektivische Darstellung, teilweise auseinandergezogen, einer weiteren Ausführungsform eines Kabelgehäuses und
- Fig. 12: ein Blattfederelement.

In den Figuren, in denen grundsätzlich gleiche Elemente mit gleichen Bezugszeichen versehen sind, sind verschiedene Ausführungsformen von Kabelgehäusen rein prinzipiell dargestellt, die ihrerseits Steckverbinder wie Federleisten oder Messerleisten aufnehmen, die in entsprechende Steckverbinder in Form von Messerleisten oder Federleisten einsteckbar sind, die von Leiterplatten wie Europa-Steckkarten ausgehen und die ihrerseits in Führungshaltern eines Baugruppenträgers eingebracht sind.

Der Baugruppenträger kann dabei einen prinzipiellen Aufbau aufweisen, wie dieser der DE 41 14 484 C2 zu entnehmen ist. Insoweit wird auf die entsprechende Offenbarung verwiesen. Losgelöst hiervon ist der Baugruppenträger derart ausgebildet, daß die erforderliche Abschirmung des Innenraums von außen als auch von innen in bezug auf elektromagnetische Felder erfolgt. Dabei ist das jeweilige Kabelgehäuse erfindungsgemäß derart weitergebildet, daß auch im Steckbereich - also im Übergangsbereich zum Baugruppenträger oder eines sonstigen abgeschirmten Gehäuses - die erforderliche elektromagnetische Abschirmung sichergestellt ist.

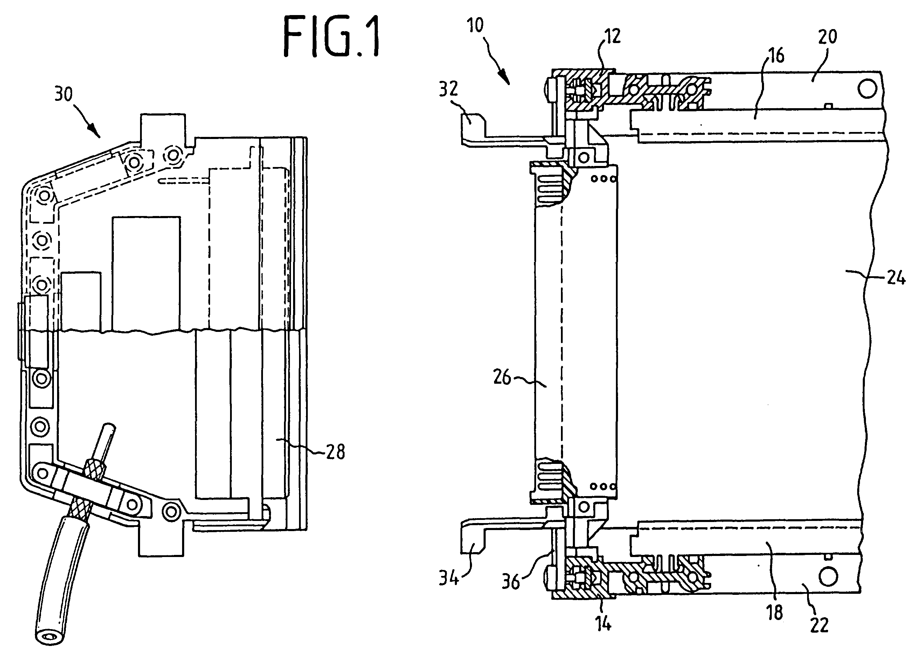

In Fig. 1 ist im Quer- und Ausschnitt ein Baugruppenträger 10 mit zwischen Profiltragschienen 12, 14 angeordneten Führungshaltern 16 und 18 dargestellt, die durch Rastverbindungen an den Profilschienen 12, 14 befestigt sind. Die Führungshalter 16, 18 erstrecken sich entlang oberer und unterer Abdeckplatte 20, 22 und weisen nicht näher bezeichnete Nuten auf, deren offene Längsseiten einander zugewandt sind. Seitenwände 21 des Baugruppenträgers 10 können mit den Profilschienen 12, 14 verschraubt sein.

Die Seitenwände 21, Abdeckplatten 20, 22, Profilschienen 12, 14 sowie eine rückseitige Abdeckplatte bestehen aus Metall, insbesondere aus Aluminium, um Abschirmfunktionen ausüben zu können.

In die Nuten der Führungshalter 16, 18 sind Bauleiterplatten wie Europa-Steckkarten 24 eingesetzt, die nicht näher dargestellte elektrische bzw. elektronische Bauelemente sowie im Ausführungsbeispiel am vorderen Ende eine Messerleiste 26 tragen, die in eine Federleiste 28 z.B. der Bauform Crimp, Wire-Wrap oder Löt einsteckbar ist.

Selbstverständlich können Messer- und Federleiste auch ausgetauscht werden. Losgelöst hiervon wird im Ausführungsbeispiel der Fig. 1 die Federleiste 28 von einem aus Metall oder metallisiertem Material bestehenden Stecker- oder Kabelgehäuse 30 aufgenommen, durch das das Innere des Baugruppenträgers an der Schnitt- oder Übergangsstelle abgeschirmt wird.

Feiner sind in der Fig. 1 von die Leiterplatte 24 und den Steckverbinder 26 umfassender Baugruppe ausgehende Führungselemente 32, 34 dargestellt, die in nicht näher bezeichneten Nuten des Kabelgehäuses 10 eingreifen, um das Kabelgehäuse 10 leicht und genau stecken zu können. Insoweit wird auf eine Konstruktion verwiesen, die der DE 26 11 941 C3 zu entnehmen ist, auf deren Offenbarung nachdrücklich Bezug genommen wird.

Der Steckverbinder 26 durchsetzt eine aus Metall bestehende Frontplatte 36, die ebenfalls mit den Profilschienen 12 und 14 verschraubt ist. Die Frontplatte 36 besteht aus Metall wie Aluminium oder aus einen, metallisierten Werkstoff, um eine Abschirmfunktion ausüben zu können.

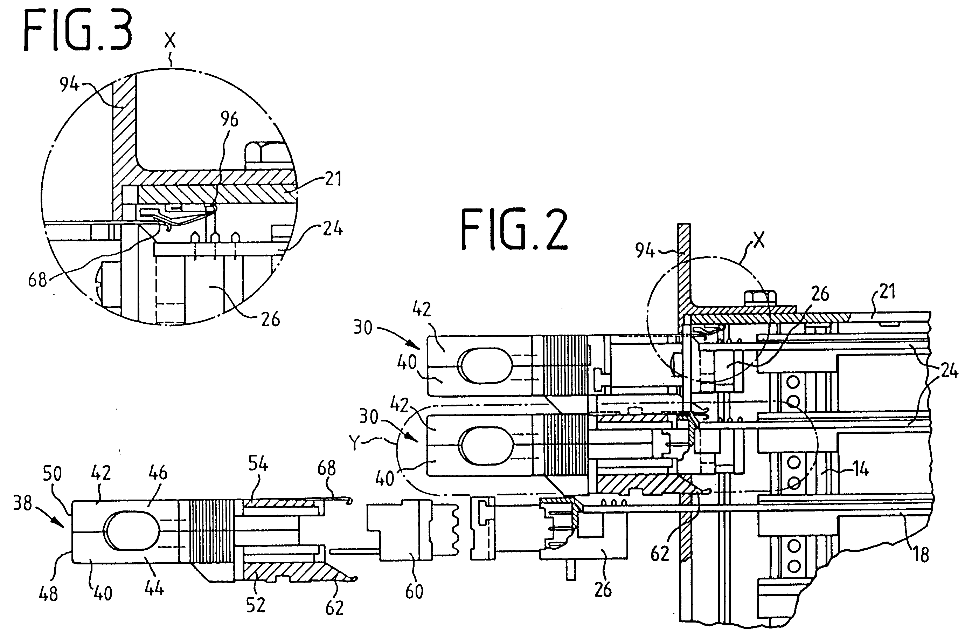

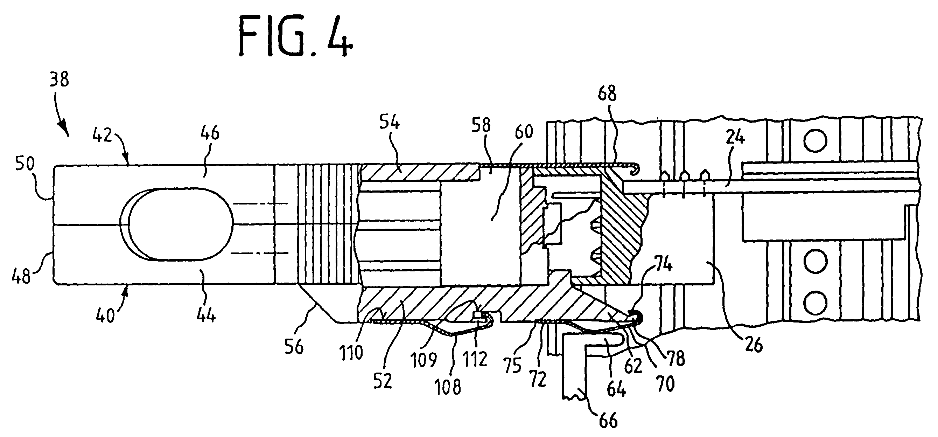

Bei dem Ausführungsbeispiel der Fig. 2 bis 4 ist ein Kabelgehäuse 38 aus zwei ungleichen Gehäuseschalen 40 und 42 zusammengesetzt, wobei jede Gehäuseschale 40, 42 ihrerseits aus Seitenwänden 44, 46, Rückwand 48, 50 sowie Basis- oder Grundwand 52, 54 besteht. Entsprechend der Darstellung der Fig. 2 und 4 weist die Basiswand 52 des Gehäuseteils 40 eine durch eine Schräge 54 gebildete Stufe auf. Dies ist jedoch kein zwingendes Merkmal.

Die Basiswand 54 des Gehäuseteils 42 weist eine Aussparung 58 bedingt durch einen nicht näher bezeichneten domartigen Vorsprung des als Federleiste ausgebildeten Steckerverbinders 60 auf.

Demgegenüber ist die Basiswand 52 der Gehäuseschale 40 an ihrem vorderen Rand als Federschenkel 62 ausgebildet, der sich bei eingestecktem Verbindungsteil innerhalb des Baugruppenträgers 10 erstreckt und entlang entweder eines Federschenkels 64 einer angrenzenden Frontplatte 66 oder eines Kontaktschenkels 68 eines angrenzenden Kabelgehäuses 30 verläuft.

Der integral von der Basiswand 52 ausgehende Federschenkel 62 dient als Aufnahme eines Federelementes 70, das sich im wesentlichen über die Breite der Basiswand 52 erstreckt und nach außen gebogen ist, um einen hinreichenden elektrisch leitenden Kontakt zu dem zugeordneten Kontaktschenkel 64 der Frontplatte 66 bzw. eines Kontaktschenkels 68 eines angrenzenden Kabelgehäuses und damit die gewünschte Abschirmung sicherzustellen.

Bei der Feder 70 handelt es sich um eine Art Blattfeder mit einem breiteren sich außenseitig entlang der Basiswand 52 erstreckenden streifenförmigen Längsrand 72, der an einer Stufe 75 der Basiswand 52 angrenzt, um in diese bündig überzugehen.

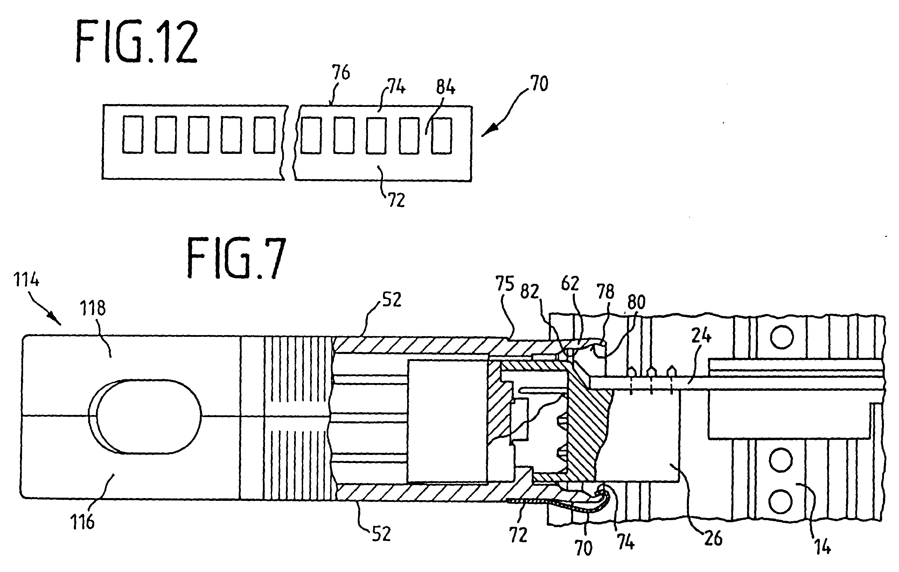

Der gegenüberliegende Längsrand 74, der schmaler ausgebildet ist, ist ebenfalls streifenförmig und erstreckt sich innenseitig entlang des stegförmig ausgebildeten Randes 76 des Federschenkels 62. Dabei liegt der Streifen 74 des Federelementes 70 durch Federspannung bedingt mit seiner äußeren Kante 76 vorzugsweise in einer nutartigen Vertiefung 80, die sich entlang der Innenfläche des Federschenkels 62 erstreckt und den Übergang zwischen der stegartigen Spitze 78 und einen, parallel zur Außenfläche der Basiswandung 52 verlaufenden Abschnitt 82 bildet. Ferner verdeutlicht die Fig. 7, daß der stegförmige Rand 78 nach innen gebogen verläuft.

Die streifenförmigen Längsränder 72, 74 des Federelementes 70 sind durch zueinander beabstandete Querstreifen 84 verbunden, wobei der lichte Abstand zwischen den Querstreifen 84 größer als die Breite der Querstreifen 84 selbst ist.

Der Längsrand 72 des Federelements 70 ist vorzugsweise mit der Basiswand 52 durch Kleben verbunden. Andere Befestigungsmöglichkeiten bestehen jedoch ebenfalls. So können die Längsränder 72, 74 in Auskammerungen des Federschenkels 62 eingelegt und über Gegenlager gesichert werden. Insoweit wird jedoch auf hinlängliche Konstruktionen und auch auf Möglichkeiten verwiesen, die aus der DE 41 14 484 C2 bekannt sind.

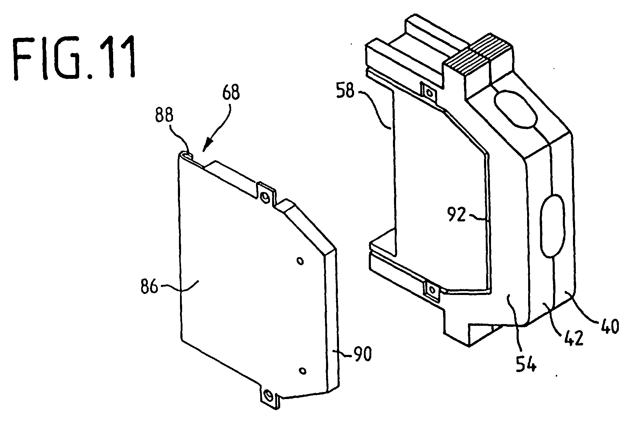

Der entlang der die Aussparung 58 aufweisenden Basiswandung 54 verlaufende Federschenkel 68 wird - wie die Prinzipdarstellung der Fig. 11 verdeutlicht - von einem Blechelemente 86, und zwar von dessen vorderen umgebogenen Rand 88 gebildet, der die Funktion einer reibschlüssigen Schneide ausüben kann. Das Blechelement 86 ist mit der Basiswand 54 verschraubt, wobei im Bereich der Basiswand 54 das Blechelement 86 abgekantet ist, um eine erforderliche Stabilität sicherzustellen. Die Abkantungen, die beispielhaft mit dem Bezugszeichen 90 versehen sind, können in entsprechende Vertiefungen 92 der Basiswand 54 eingreifen.

Das Blechelement 86 kann so dünn gewählt werden, daß bei Erzielung der gewünschten Abschirmwirkung das Kabelgehäuse 38 die benötigten Seitenabmessungen nicht derart überschreitet, daß ein Einbau in den Baugruppenträger 10 nicht mehr möglich wäre.

Verläuft im Bereich einer Seitenwandung 21, von der Befestigungsschenkel 94 ausgehen können, eine Steckverbindung mit einem Kabelgehäuse 38, so kann von den Innenfläche der Seitenwand 21 ein Federelement 96 ausgehen und dort befestigt werden, wie dies dem Deutschen Patent 41 14 484 zu entnehmen ist. Mit dem Federelement 96 wirkt sodann der Kontaktschenkel 68 bei zusammengesteckter Steckverbindung zusammen, um den erforderlichen elektrisch leitenden Kontakt zwischen dem Kabelgehäuse 38 und dem Baugruppenträger 10 und damit die Abschirmwirkung sicherzustellen.

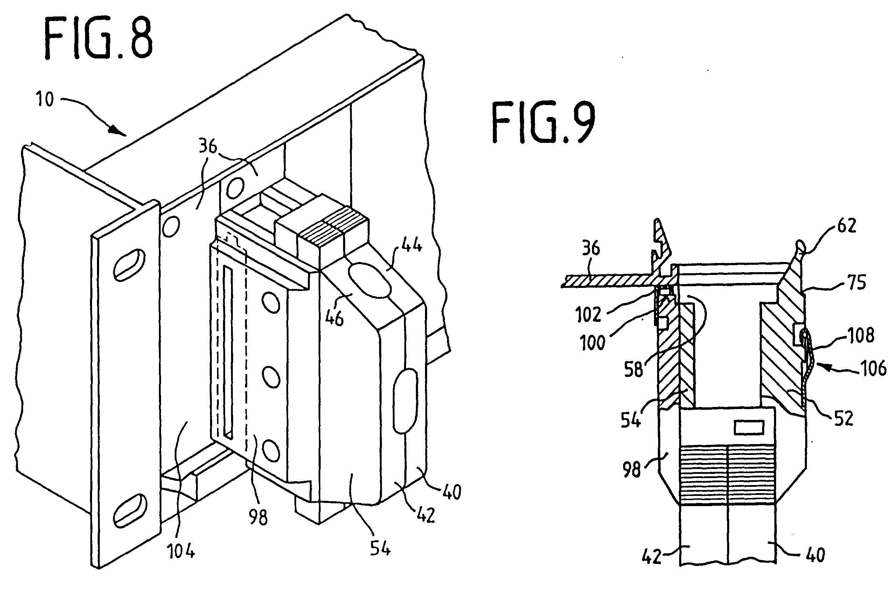

Nach den Fig. 8 und 9 kann auf die Basiswand 54 der Gehäuseschale 42 ein aus elektrisch leitendem Material wie Aluminium bestehender Aufsatz 98 geschraubt werden, der die Aussparung 58 abdeckt und stirnrandseitig 100 ein über dessen gesamte Länge erstreckendes Federelement 102 aufweist, welches sich an der Außenfläche 104 der Frontplatte 36 leitend abstützt.

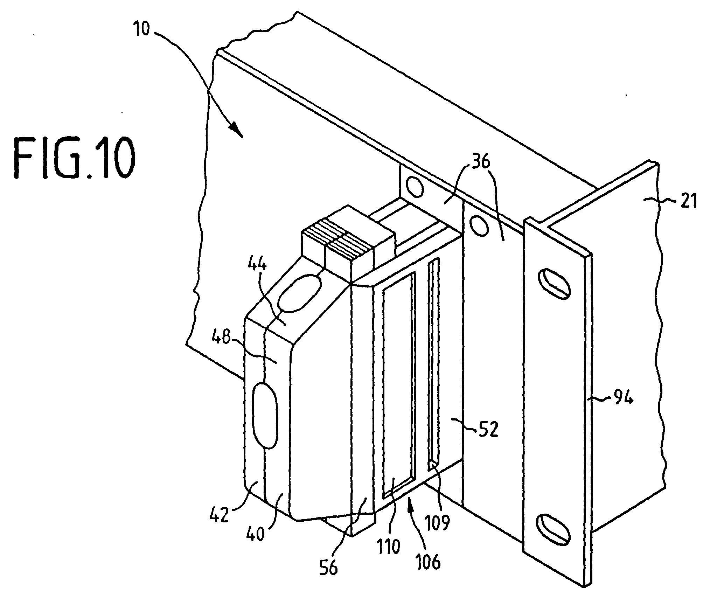

Aus der Schnittdarstellung der Fig. 9 wie auch aus der perspektivischen Darstellung gemäß Fig. 10 ergibt sich des weiteren, daß im Abstand zur Vorderseite des Gehäuseteils 40 außenwandseitig eine Aufnahme 106 für ein Federelement 108 verläuft, über die ein elektrisch leitender Kontakt zu einem angrenzenden Kabelgehäuse herstellbar ist. Hierzu weist die Aufnahme 106 eine vordere kammerartige Vertiefung 109 und eine hintere stufenförmige Vertiefung 110 auf, in die das Federelement 108 einbringbar und festlegbar ist. Die schlitzförmige und sich nahezu über die gesamte Breite der Gehäuseschale 40 erstreckenden Vertiefungen 109, 110 verlaufen parallel zueinander.

Die Geometrie des Federelementes 108 kann dabei prinzipiell der des Federelementes 70 entsprechen, weist folglich in seinem oberen Bereich einen nach innen abgewinkelten Rand auf, der einen die Kammer 109 außenseitig begrenzenden Steg 112 umgibt, wie dies auch durch die Fig. 4 verdeutlicht wird.

Der Längsrand des Federelementes kann in der Vertiefung 110 festgeklebt oder in anderer geeigneter Weise z.B. auch durch Lager und Widerlager festgelegt werden.

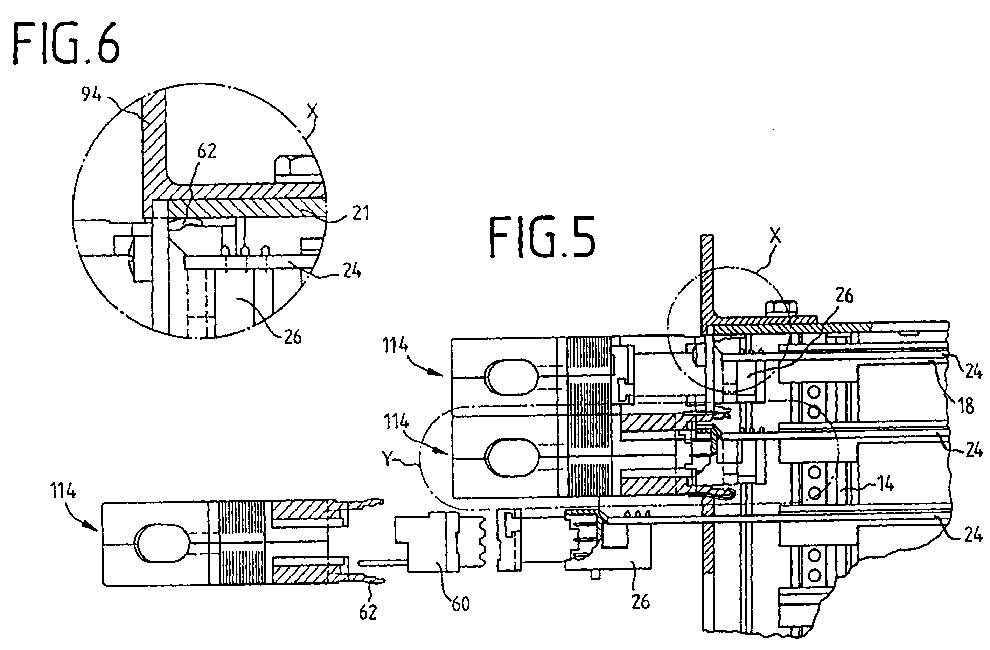

Das Ausführungsbeispiel der Fig. 5 bis 7 unterscheidet sich von den zuvor beschriebenen dahingehend, als daß ein Kabelgehäuse 114 aus zwei identischen Schalen 116, 118 zusammengesetzt ist, die in bezug auf die Schenkelausbildungen identisch mit der Gehäuseschale 40 übereinstimmen. Insoweit wird auf die entsprechende Beschreibung verwiesen. Einziger Unterschied ist darin zu sehen, daß die Seitenwandung 52 eben verläuft, also sich nicht aus zwei über die Schräge 56 getrennt und versetzt zueinander verlaufenden parallelen Wandabschnitten zusammensetzt. Auch verdeutlicht insbesondere die Fig. 7, daß der Kontakt - und der Federschenkel identisch ausgebildet sind, so daß gleiche Bezugszeichen 62 verwendet worden sind.

Unabhängig von den zuvor beschriebenen bevorzugten Ausführungsformen ist die erfindungsgemäße Lehre überall dort anwendbar, wo eine Abschirmung zwischen der Schnittstelle eines Kabelgehäuses und eines abgeschirmten sonstigen Gehäuses gewünscht wird.

## Patentansprüche

1. Kabelgehäuse (30, 38, 114) zur Aufnahme eines Steckverbinders (28, 60) wie Feder- oder Messerleiste zum Verbinden mit einem Steckverbinder (26) wie Messer- oder Federleiste einer in einem abgeschirmten Gehäuse wie Baugruppenträger (10) anordbaren Baugruppe (24), wobei das Kabelgehäuse zwei miteinander verbindbare Gehäuseteile mit Seitenwänden (44, 46), Rückwand (48, 50) und Basiswand (52, 54) umfaßt,
**dadurch gekennzeichnet**,
daß von der Basiswand (52, 54) der Gehäuseschale (40, 42, 116, 118) ausgehend oder entlang dieser sich erstreckend ein Kontakt- und/oder Federschenkel (62, 68, 98) zur Ausbildung einer elektrisch leitenden Verbindung mit einem angrenzenden weiteren Kabelgehäuse oder einem Abschnitt des abgeschirmten Gehäuses (10) ausgeht.

2. Kabelgehäuse nach Anspruch 1,
**dadurch gekennzeichnet**,
daß der Kontakt- bzw. Federschenkel (62) integral mit der Basiswand (52) ausgebildet ist.

3. Kabelgehäuse nach Anspruch 1 oder 2,
**dadurch gekennzeichnet**,
daß der Federschenkel (62) vorderer stirnrandseitiger Abschnitt der Basiswand (52) ist, daß außenseitig und bündig in die Basiswand übergehend ein Federelement (70) verläuft, die den Federschenkel endseitig umgibt sich bis zur Innenseite des Federschenkels erstreckt.

4. Kabelgehäuse nach zumindest einem der vorhergehenden Ansprüche,
**dadurch gekennzeichnet**,
daß das Federelement (70) parallel zum vorderen Längsrand (78) des Federschenkels (62) verlaufend und außen- und innenseitig an der Basiswand (52) anliegend äußere und innere Ränder bildende Längsstreifen (72, 74) aufweist, die über senkrecht zu diesen verlaufende und zueinander beabstandete Querstreifen (84) verbunden sind.

5. Streckergehäuse nach zumindest einem der vorhergehenden Ansprüche,
**dadurch gekennzeichnet**,
daß die Querstreifen (84) in ihren außen entlang der Basiswand (52) verlaufenden Bereichen nach außen gebogen sind.

6. Kabelgehäuse nach zumindest einem der vorhergehenden Ansprüche,
**dadurch gekennzeichnet**,
daß der äußere Längsstreifen (72) des Federelementes (70) randseitig an einer Stufe (75) der Basiswand (52) angrenzt.

7. Kabelgehäuse nach zumindest einem der vorhergehenden Ansprüche,
**dadurch gekennzeichnet**,
daß der äußere Längsstreifen (72) des Federelementes (70) an der Basiswand (52) befestigt wie geklebt ist.

8. Kabelgehäuse nach zumindest einem der vorhergehenden Ansprüche,
**dadurch gekennzeichnet**,
daß der innere Längsstreifen (74) des Federelementes (70) randseitig in einer Längsnut (80) der Innenfläche der Basiswand (52) verläuft.

9. Kabelgehäuse nach zumindest einem der vorhergehenden Ansprüche,
**dadurch gekennzeichnet**,
daß die Querstreifen (72, 74) des Federelementes (70) senkrecht zu einer außenwandigen Längsrippe der Basiswand (52) verlaufen.

10. Kabelgehäuse nach zumindest einem der vorhergehenden Ansprüche,
**dadurch gekennzeichnet**,
daß die Basiswand (52) stirnrandseitig nach innen abgewinkelt ist.

11. Kabelgehäuse nach zumindest einem der vorhergehenden Ansprüche,
**dadurch gekennzeichnet**,
daß die innenwandseitige Längsnut (80) des Federschenkels (62) zwischen dem nach innen abgewinkelten Längsrand (78) und parallel zur Außenfläche der Basiswand (52) verlaufender Innenfläche (82) des Federschenkels (62) verläuft.

12. Kabelgehäuse nach zumindest einem der vorhergehenden Ansprüche,
**dadurch gekennzeichnet**,
daß der Kontaktschenkel gleich dem Federschenkel (62) ausgebildet ist.

13. Kabelgehäuse nach zumindest einem der vorhergehenden Ansprüche, wobei zumindest eine Gehäuseschale (42) eine von deren vorderem Rand ausgehende Ausnehmung bzw. Aussparung (58) aufweist,
**dadurch gekennzeichnet**,
daß die Aussparung (58) von einem mit der Gehäuseschale (42) verbindbare Blechelement (86) mit parallel zum Längsrand der Gehäuseschale verlaufenden und über diesen vorstehenden Randabschnitt (88) abgedeckt ist, der Schenkel wie Kontaktschenkel (68) zur Ausbildung einer leitenden Verbindung mit einem angrenzenden weiteren Kabelgehäuse oder einem Abschnitt des Baugruppenträgers (10) ist.

14. Kabelgehäuse nach zumindest einem der vorhergehenden Ansprüche,
**dadurch gekennzeichnet**,
daß der Randabschnitt (88) des Blechelementes (86) nach innen umgebogen ist.

15. Kabelgehäuse nach zumindest einem der vorhergehenden Ansprüche,
**dadurch gekennzeichnet**,
daß das Blechelement (86) gehäuseseitig zumindest abschnittsweise abgekantet ist.

16. Kabelgehäuse nach zumindest einem der vorhergehenden Ansprüche,
**dadurch gekennzeichnet**,
daß das Blechelement (86) mit der Basiswandung (54) verschraubt ist.

17. Kabelgehäuse nach zumindest einem der vorhergehenden Ansprüche,
**dadurch gekennzeichnet**,
daß Abkantungen (90) des Blechelementes (86) in angepaßte Aufnahmen (92) der Basiswandung (54) eingreifen.

18. Kabelgehäuse nach zumindest einem der vorhergehenden Ansprüche,
**dadurch gekennzeichnet**,
daß außenseitig entlang der Basiswandung (54) der Gehäuseschale (42) und die Aussparung (58) abdeckend ein Aufsatz (98) befestigt ist, entlang dessen Stirnseite sich ein an dem abgeschirmten Gehäuse wie Baugruppenträger (10) oder einem Abschnitt von diesem wie Frontplatte (36) anliegendes Federelement (102) erstreckt.

19. Kabelgehäuse nach zumindest einem der vorhergehenden Ansprüche,
**dadurch gekennzeichnet**,
daß beabstandet zum integral mit der Basiswand (52) ausgebildeten Feder- bzw. Kontaktschenkel (62) und parallel zu dessen Längsrand (78) außenflächig in der Basiswand über oder nahezu über dessen Breite eine Aufnahme (106) für ein zweites Feder- wie Blattfederelement (108) vorgesehen ist.

20. Kabelgehäuse nach zumindest einem der vorhergehenden Ansprüche,
**dadurch gekennzeichnet**,
daß in der Außenfläche der Basiswand (52) eine parallel zu deren Stirnrand verlaufende kammer- oder schlitzförmige Aussparung zur Aufnahme eines Längsrand des entlang der Basiswand verlaufenden Federelements (108) wie Blattfeder verläuft, dessen anderer Längsrand von einem U- bzw. keisabschnittförmig gebogenen Endbereichs des Federelementes ausgeht, der einen eine kammerförmige Aussparung (109) außenseitig begrenzenden Steg (112) umgibt.
